# EUROPÄISCHE PATENTSCHRIFT

(11) **EP 3 176 820 B1**
(45) Veröffentlichungstag und Bekanntmachung des Hinweises auf die Patenterteilung: **25.07.2018**
(21) Anmeldenummer: 16196070.3
(22) Anmeldetag: 27.10.2016
(51) Int. Cl.: H01L 23/473, C09K 5/10, F28F 19/00

(54) **KÜHLVORRICHTUNG**
COOLING DEVICE
DISPOSITIF DE REFROIDISSEMENT

(30) Priorität: 24.11.2015 DE 102015223208
(43) Veröffentlichungstag der Anmeldung: 07.06.2017
(73) Patentinhaber: Siemens Aktiengesellschaft, 80333 München (DE)
(72) Erfinder: Benkert, Katrin, 90571 Schwaig (DE); Holweg, Johann, 90513 Zirndorf (DE); Landes, Harald, 90607 Rückersdorf (DE); Leonide, André, 90762 Fürth (DE)

(56) Entgegenhaltungen:
- EP-A1- 1 416 563
- IMMO WEBER ET AL: "Behavior of Highly Diluted Electrolytes in Strong Electric Fields-Prevention of Alumina Deposition on Grading Electrodes in HVDC Transmission Modules by CO 2 -induced pH-Control", CHEMISTRY - A EUROPEAN JOURNAL, Bd. 20, Nr. 38, 15. September 2014 (2014-09-15), Seiten 12091-12103, XP055368368, ISSN: 0947-6539, DOI: 10.1002/chem.201400165

## Beschreibung

Die Erfindung betrifft eine Kühlvorrichtung beispielsweise für ein elektrisches Bauteil nach dem Patentanspruch 1 sowie ein Verfahren zum Betreiben einer Kühlvorrichtung für ein elektrisches Bauteil nach Patentanspruch 7. Für elektrische Bauteile, insbesondere Leistungshalbleiter wie Thyristoren und IGTB's, bei denen im Betrieb sehr viel Wärme umgesetzt wird, sind aufwendige Kühlvorrichtungen notwendig. Ein Beispiel hierfür sind die Stromrichteranlagen in HGÜ-Systemen (Hochspannungsgleichstromübertragung = HGÜ). In derartigen Kühlvorrichtungen sind Steuerelektroden angeordnet, die im Wesentlichen aus Platin bestehen und die dazu dienen, in einzelnen Kühldosen einen Spannungsgradienten zu verhindern, der dazu führen könnte, dass sich dort Ablagerungen bilden. Stattdessen sind jedoch die Steuerelektroden bei einer anodischen Belastung, also bei Anliegen eines positiven Potentials, von Ablagerungen aus Aluminiumverbindungen betroffen. Diese Aluminiumverbindungen, die sich an den Steuerelektroden ablagern, können beispielsweise vom Aluminiumkühlkörpern, die in dem gesamten Kühlsystem integriert sind, stammen. Diese Ablagerungen stören einerseits die Potentialanbindung an das Kühlwasser und führen andererseits dazu, dass sie nach einiger Zeit abplatzen und dabei zum Verschluss von Kühlkanälen und damit zum Ausfall der elektronischen Bauteile, beispielsweise der Thyristoren führen. Es ist bekannt, dass die Stabilität dieser Ablagerungen vom pH-Wert des Wassers abhängt. So hat sich in Versuchen gezeigt, dass eine Zuspeisung sehr geringer Mengen von Kohlendioxid, das im Kühlwasser gelöst ist und das eine Absenkung des pH-Wertes herbeiführt, die Bildung der Beläge verhindert oder zumindest hemmt. Die Zudosierung von Kohlendioxid ist aber aufwendig und muss sehr präzise erfolgen, damit die Leitfähigkeit des Kühlwassers nicht zu stark ansteigt und die Korrosion der Kühldosen und anderer Anlagenkomponenten nicht zu stark gefördert wird. Hierzu sei auf die Veröffentlichung von IMMO WEBER ET AL: "Behavi or of Highly Diluted Electrolytes in Strang Electric Fields-Prevention of Alumina Deposition on Grading Electrodes in HVDC Transmission Modules by CO 2 - induced pH-Control11, CHEMISTRY - A EUROPEAN JOURNAL, Bd. 20, Nr. 38, 15. September 2014 (2014-09-15), Seiten 12091-12103, XP055368368, ISSN: 0947-6539 verwiesen, die eine Kühlvorrichtung für Leistungshalbleiter beschreibt. Ferner sei auf die EP 1 416 563 A1 verwiesen, die eine Kühlvorrichtung auf Wasserbasis zur Kühlung einer Brennstoffzelle beschreibt.

Die Aufgabe der Erfindung besteht darin, eine Vorrichtung, ein Verfahren sowie ein Kühlmedium bereitzustellen, durch die bzw. durch das Ablagerungen auf den Steuerelektroden reduziert werden.

Die Lösung der Aufgabe besteht in Form einer Kühlvorrichtung für ein elektrisches Bauteil oder Bauteil nach Anspruch 1 sowie in einem Verfahren zum Betreiben einer Kühlvorrichtung nach Anspruch 8 und in einem Kühlmedium zur Verwendung in einer Kühlvorrichtung nach Anspruch 10.

Die erfindungsgemäße Kühlvorrichtung für ein elektrisches Bauteil nach Patentanspruch 1 umfasst einen Kühlkreislauf mit einem Kühlmedium auf Basis von Wasser. Ferner umfasst die Kühlvorrichtung eine im Kühlkreislauf enthaltene Elektrode, die vom Kühlmedium umflossen wird. Die Erfindung zeichnet sich dadurch aus, dass das Kühlmedium einen Zusatzstoff enthält, der zwischen 1 vol% und 10 vol% des gesamten Kühlmediums ausmacht und der wasserlöslich, nichtionisch ist und ohne weitere äußere Einflüsse nicht in Wasser dissoziiert.

Es hat sich herausgestellt, dass Stoffe, die diese drei wesentlichen Kriterien, wasserlöslich, nichtionisch und nichtdissoziierend, aufweisen, sich beim Umfließen der Elektrode, also in der Nähe der Elektrode, hervorgerufen durch die anliegende Spannung, in geringem Umfang zersetzen. Bei dieser Zersetzung der erwähnten Stoffklassen werden pH-Wert senkende Produkte, wie z. B. Kohlendioxid frei, das wiederum lokal um die Elektrode herum eine Absenkung des pH-Wertes des gesamten Kühlmediums bewirkt. Das gesamte Kühlmedium, das im Wesentlichen auf Basis von Wasser besteht, hat einen nahezu neutralen pH-Wert, der in einer Größenordnung zwischen 6,8 und 7,2 liegt. Durch die spontane Zersetzung des Zusatzstoffes und die Bildung des Kohlendioxids wird der pH-Wert in der Region der Elektrode deutlich unter den genannten Wert herabgesetzt. D.h. also, im Bereich um die Elektrode herum herrscht ein weitgehend saures Medium vor, was die Bildung von Ablagerungen auf der Elektrode verhindert. Da das Kühlmedium ständig in Bewegung ist und im Kühlkreislauf weitergeführt wird, löst sich dieser Effekt durch Verdünnungseffekte nach der Elektrode wieder auf, so dass das Kühlwasser außerhalb der nächsten Elektrodenumgebung wieder den oben erwähnten nahezu neutralen pH-Wert annimmt.

Es hat sich herausgestellt, dass insbesondere Alkohole, wie beispielsweise Ethylenglykol, Saccharide, wie beispielsweise Zucker, oder Formiat, also Ameisensäure, besonders geeignet sind, als Zusatzstoff die beschriebene Wirkung zu vollziehen.

Eine derartige Kühlvorrichtung ist weiterhin besonders zweckmäßig zur Kühlung von Leistungshalbleitern, beispielsweise Thyristoren oder sogenannte IGBT's. Derartige Bauteile finden insbesondere in Stromrichteranlagen Anwendung, beispielsweise in Stromrichteranlagen für HGÜ-Anlagen.

Es hat sich ferner herausgestellt, dass die Kühlvorrichtung in einer vorteilhaften Ausgestaltungsform einen Ionentauscher enthält, der Zersetzungsprodukte, die bei der beschriebenen Reaktion in Elektrodennähe entstehen, aus dem Kühlkreislauf entfernt. Entsprechend wird anschließend der zersetzte Zusatzstoff in den Kühlkreislauf nachdosiert.

Ein weiterer Bestandteil der Erfindung besteht in einem Verfahren zum Betreiben einer Kühlvorrichtung für ein elektrisches Bauteil. Das Verfahren zeichnet sich dadurch aus, dass die Kühlvorrichtung mit einem Kühlmedium befüllt wird, das auf Wasserbasis besteht. Dem Kühlmedium wird ein wasserlöslicher, nichtionischer und nichtdissoziierender Stoff zugefügt, der im Kühlmedium zwischen 1 vol% und 10 vol% einnimmt.

Die Vorteile des erfindungsgemäßen Verfahrens gemäß Patentanspruch 8 sind dieselben, die bereits bezüglich des Patentanspruches 1 dargelegt sind. Ferner ist es auch hier zweckmäßig, dass der Zusatzstoff ein Alkohol, ein Saccharid oder ein Formiat enthält.

Ein weiterer Bestandteil der Erfindung ist ein Kühlmedium, das zur Verwendung in einer Kühlvorrichtung nach einem der Ansprüche 1 bis 7 vorgesehen ist.

Weitere Merkmale bzw. weitere spezielle Ausgestaltungsformen der Erfindung werden anhand der folgenden Zeichnungen näher erläutert. Dabei handelt es sich um rein exemplarische Ausgestaltungsformen, die keine Einschränkung der Schutzbereichs darstellen.

Dabei zeigen:
- FIG 1: eine Darstellung einer Kühlvorrichtung und
- FIG 2: eine vergrößerte Darstellung des Ausschnittes II aus Figur 1.

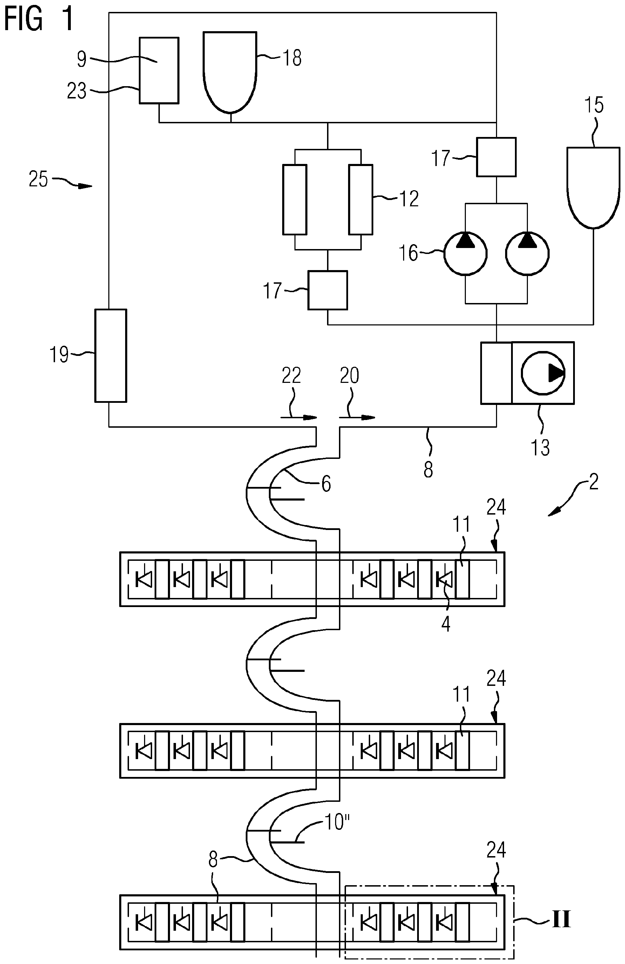

In FIG 1 ist eine Kühlvorrichtung 2 zur Kühlung von elektronischen Bauteilen 4 dargestellt. Bei den vorliegenden elektronischen Bauteilen 4 handelt es sich exemplarisch um Thyristoren, die wiederum ein Teil einer Stromrichteranlage sind. Die hier dargestellte Stromrichteranlage wiederum ist Teil einer Hochspannungsgleichstromübertragungsanlage (HGÜ). Grundsätzlich ist die beschriebene Kühlvorrichtung für eine Vielzahl von Applikationen geeignet, insbesondere, aber nicht eingeschränkt, auf die Kühlung von elektrischen Bauteilen. Sie ist insbesondere dort zweckmäßig, wo eine Vielzahl von Einzelkomponenten gekühlt werden muss und daher komplexe Strömungsverhältnisse für das Kühlmedium zu steuern sind.

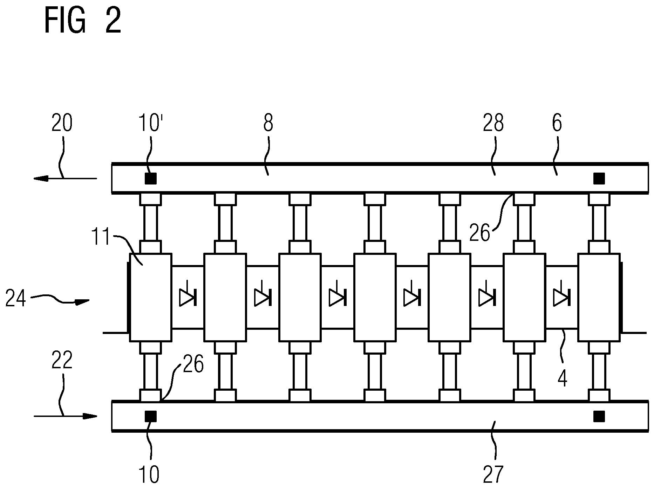

Die Kühlvorrichtung 2 ist in der Darstellung in FIG 1 graphisch in zwei Blöcke getrennt, ein Block stellt ein Aufbereitungsmodul 25 dar, das im Wesentlichen zur Aufbereitung eines Kühlmediums 8 dient, der andere Block wird durch eine Mehrzahl von Thyristormodulen 24 gebildet. Im Weiteren wird nun ein gesamter Kühlkreislauf 6 beschrieben, der sowohl die die Thyristormodule 24 als auch das Aufbereitungsmodul 25 durchfließt. Dabei wird zunächst auf die Thyristormodule 24 eingegangen, die zum einen ein elektronisches Bauteil 4 in Form eines Thyristors umfassen, wobei jeweils ein elektronisches Bauteil 4 mit einer Kühldose 11 in direktem Kontakt steht, so dass die in dem Bauteil 4 anfallende thermische Energie abgeführt werden kann. Die Kühldose 11 und das elektronische Bauteil 4 ist vergrößert in der FIG 2 dargestellt. Hierbei ist zu erkennen, dass über einer Kaltwasserzufuhr 22 kühleres Kühlmedium 8, das im Wesentlichen aus Wasser besteht und auf dessen Zusammensetzung noch detaillierter eingegangen wird, dem Thyristormodul 24 zugeführt wird. Entlang der Leitung 27 des Kaltwasserstromes 22 sind Abzweigungen 26 vorgesehen, die den Kaltwasserstrom 22 in die Kühldosen 11 leiten. Auf der gegenüberliegenden Seite des Thyristormoduls 24 ist eine analoge Warmwasserleitung 28 angeordnet, die auch wieder Abzweigungen 26 aufweist, in denen das in den Kühldosen 11 erwärmte Kühlmedium 8 abgeleitet wird.

In den Thyristormodulen 24 sind in regelmäßigen Abständen Elektroden 10 bzw. 10' vorgesehen, die in den Kaltwasserleitungen 27 und Warmwasserleitungen 28, in der Regel jeweils parallel an gegenüberliegenden Abzweigungen 26 angeordnet sind. Diese Elektroden 10, 10' dienen dazu, eine Differenz des elektrischen Potentials zwischen den Leitungen 27 und 28 bzw. zwischen den Kühlmediumströmungen 22 und 20 zu unterbinden.

Wie in FIG 1 zu erkennen ist, werden exemplarisch mehrere Thyristormodule 24 von dem Kühlkreislauf 6 durchlaufen, wobei jeweils aufbereitetes, gereinigtes Kühlmedium 8 in Form eines Kaltwasserstromes aus dem Aufbereitungsmodul 25 in den Kühlkreislauf 6 eingeleitet wird und erwärmtes Kühlmedium in Form des Warmwasserstromes 20 in das Aufbereitungsmodul 25 zurückfließt.

Das Aufbereitungsmodul 25 umfasst dabei eine Mehrzahl von Komponenten, die im oberen Teil der FIG 1 exemplarisch und nicht vollständig dargestellt sind. Auf die einzelne Komponenten des Aufbereitungsmoduls 25, das in der Praxis nicht notwendigerweise in Form eines zusammengefassten integralen Moduls vorliegen muss, wird im Weiteren eingegangen. Dabei ist der Begriff Aufbereitungsmodul für eine Sammlung von Komponenten der Kühlvorrichtung gewählt, die nicht zum alleinig elektronisch wirksamen Thyristormodul gehören, die aber auch nicht zwangsläufig räumlich gebündelt angeordnet sein müssen.

Das Aufbereitungsmodul 25 umfasst zunächst eine Kühlvorrichtung 13, die den Warmwasserstrom 20, also das erwärmte Kühlmedium 8 effektiv abkühlen kann. Ferner umfasst das Modul 25 eine oder mehrere Pumpen 16, die für den Gesamtstrom des Kühlmediums 8 im Kühlkreislauf 6 sorgen, sowie verschiedene Filter 17 und Sensor-Vorrichtungen 19, durch die eine Überprüfung der physikalischen und chemischen Eigenschaften des Kühlmediums, insbesondere bei Eintritt des abgekühlten Kühlmediums 8 in den Kühlkreislauf 6 dienen. Ein weiterer zweckmäßiger Bestandteil des Aufbereitungsmoduls 25 ist ein Ionentauscher 12, der zur Aufbereitung des Kühlmediums 8 dient und durch den gegebenenfalls Verunreinigungen, die während des Durchlaufens des Kühlmediums 8 durch den Kühlkreislauf 6 entstehen, elektrochemisch beseitigt werden. Auf etwaige Verunreinigungen dieser Art wird in dieser Beschreibung noch eingegangen werden. Ferner sind im Aufbereitungsmodul 25 noch ein Expansionsbehälter 15 sowie eine Zufuhr von Frischwasser 18 zu erwähnen. Ein weiterer Bestandteil ist eine Nachdosierungsvorrichtung 23, in dem ein Zusatzstoff 9 dem Kühlmedium 8 zugeführt werden kann. Auch auf diesen Zusatzstoff 9 wird im Weiteren noch eingegangen werden.

An den Elektroden 10, die auch als Steuerelektroden bezeichnet werden und die in der Regel aus Platin bestehen, bilden sich bei anodischer Belastung, also beim Anlegen eines positiven Potentials an die Elektrode 10, feste Ablagerungen aus Aluminiumverbindungen, die im Wesentlichen von Aluminiumkühlkörpern stammen, die Bestandteil der Kühlvorrichtung 13 sind. In der Regel besteht das Kühlmedium 8 aus hochreinem Wasser, aus dem im Ionentauscher 12 nach Durchlaufen des Kühlkreislaufes 6 verunreinigende Ionen entfernt werden. Dennoch kommt es zu den genannten Ablagerungen von Aluminiumverbindungen auf den Elektroden 10. Diese Ablagerungen können einerseits die Wirkungsweise der Elektroden 10 negativ beeinflussen und sie können bei Abplatzen die Filtersysteme, beispielsweise die Filter 17 der Kühlvorrichtung 2, verstopfen. Es hat sich experimentell herausgestellt, dass durch eine Absenkung des pH-Wertes des Kühlmediums 8, der in der Regel sehr nahe bei dem neutralen Wert 7 liegt und sich üblicherweise in einem Band zwischen dem pH-Wert 6,8 und 7,2 bewegt, eine Reduktion der Ablagerungen bewirkt werden kann. Das Kühlmedium 8 kann nicht grundsätzlich so ausgestaltet sein, dass es einen deutlich niedrigeren also sauren pH-Wert aufweisen, da es sonst zu Korrosion in Bauteilen der Kühlvorrichtung 2 kommen könnte. Daher ist eine lokale Absenkung des pH-Wertes im Bereich der Elektroden 10 im Kühlkreislauf 6 ein Weg, die Ablagerungen an den Elektroden 10 zu reduzieren oder zu unterbinden. Hierbei hat sich herausgestellt, dass die Zugabe des Zusatzstoffes 9 in das Kühlmedium 8 einen derartigen Effekt erzielen kann. Dabei ist es notwendig, dass es sich bei dem Zusatzstoff 9 um einen Stoff handelt, der zum einen wasserlöslich ist, der nichtionisch ist und der in dem Trägermittel des Kühlmediums 8, also dem Wasser, nicht spontan dissoziiert. Dieser Zusatzstoff 9 sollte dem Kühlmedium in einem Umfang zwischen 1 vol% und 10 vol% zugefügt werden. Es hat sich herausgestellt, dass insbesondere Alkohole, Saccharide, also Arten des Zuckers oder Formiat, also Ameisensäure, diese Aufgabe als Zusatzstoff 9 wirkungsvoll erfüllen können.

Ist der Zusatzstoff 9 dem Kühlmedium 8 zugegeben, so bleibt aufgrund der nichtionischen und dissoziierenden Eigenschaften des Zusatzstoffes der pH-Wert des Kühlmediums nahezu unverändert und liegt wiederum nahe am neutralen Bereich 7. Dieses Kühlmedium 8, das nun den Zusatzstoff 9 umfasst, wird im Kühlkreislauf 6 geleitet und umströmt dabei kontinuierlich die Elektroden 10. In dem hier genannten Beispiel ist dem Kühlmedium 8 Ethylenglykol mit 5 vol% zugegeben. Die Steuerströme der Elektroden 10 liegen in einem Bereich von unter 1 mA. Beim Vorbeiströmen des Kühlmediums 8 wird der Zusatzstoff durch die anliegende elektrische Spannung bzw. den anliegenden elektrischen Strom von weniger als 1 mA zumindest teilweise zersetzt. Dabei entsteht unter anderem Kohlendioxid, das wiederum lokal im Bereich der Elektrode während des Vorbeiströmens den pH-Wert des Kühlmediums erniedrigt. Lokal kann hierbei ein pH-Wert des Kühlmediums auftreten, der zwischen den Werten pH4 und pH5, also im sauren Bereich liegt. Es ist dabei aber zu betonen, dass dieser Wert nur lokal im Bereich der Elektrode 10 vorliegt und dass das gebildete CO₂ sowie ein Rest des teilweise zersetzten Zusatzstoffes 9 durch den Fluss des Kühlmediums 8 kontinuierlich weiter befördert wird. Genauso zersetzt sich an der Elektrode 10 kontinuierlich neu nachgeführter Zusatzstoff 9 im Kühlmedium 8 und es bildet sich weiteres Kohlendioxid. Das abgeführte Kohlendioxid wiederum löst sich in dem Kühlmedium 8 wieder auf und wird dabei stark verdünnt. Dies bewirkt, dass nur im Bereich der Elektrode 10 das dort kontinuierlich erzeugte Kohlendioxid die Herabsetzung des pH-Wertes des Kühlmediums 8 bewirkt.

Untersuchungen haben ergeben, dass die Zufuhr der genannten 5 vol% des Ethylenglykols die Ablagerungen an der Elektrode 10 bezogen auf die Zeiteinheit um bis zu 80 % reduzieren kann. Dabei ist noch anzugeben, dass die Leitfähigkeit des Kühlmediums 8 weniger als 0,5 pS/cm beträgt, eine typische Flussrate des Kühlmediums 8 liegt bei 4 l/min pro Kühldose 11, wobei das Kühlmedium eine typische Temperatur von 50 bis 60°C aufweist.

## Patentansprüche

1. Kühlvorrichtung (2) zur Kühlung elektrischer Bauteile in Form eines Leistungshalbleiters (4) umfassend einen Kühlkreislauf (6) mit einem Kühlmedium (8) auf Basis von Wasser, sowie eine vom Kühlmedium umflossene Elektrode (10), **dadurch gekennzeichnet, dass** das Kühlmedium zwischen 1 vol% und 10 vol% einen wasserlöslichen, nichtionischen und nicht dissoziierenden Zusatzstoff (9) enthält.

2. Kühlvorrichtung nach Anspruch 1, **dadurch gekennzeichnet, dass** der Zusatzstoff ein Alkohol oder ein Saccharid oder ein Formiat enthält.

3. Kühlvorrichtung nach Anspruch 1 oder 2, **dadurch gekennzeichnet, dass** das elektronische Bauteil (4) ein Thyristor oder ein IGBT ist.

4. Kühlvorrichtung nach einem der vorhergehenden Ansprüche, **dadurch gekennzeichnet, dass** das elektrische Bauteil (4) Teil einer Stromrichteranlage ist.

5. Kühlvorrichtung nach Anspruch 4, **dadurch gekennzeichnet, dass** die Stromrichteranlage Teil einer Hochspannungsgleichstromübertragungsanlage ist.

6. Kühlvorrichtung nach einem der vorhergehenden Ansprüche, **dadurch gekennzeichnet, dass** die Kühlvorrichtung einen Ionentauscher (12) umfasst.

7. Verfahren zum Betreiben einer Kühlvorrichtung, zur Kühlung elektrischer Bauteile (4)in Form eines Leistungshalbleiters, umfassend einen Kühlkreislauf (6) sowie eine vom Kühlmedium umflossene Elektrode (10), umfassend folgenden Schritt: Befüllen der Kühlvorrichtung mit einem Kühlmedium auf Wasserbasis, der und einen wasserlöslichen, nichtionischen und nicht dissoziierenden Stoff enthält, der im Kühlmedium zwischen 1 vol% und 10 vol% vorliegt.

8. Verfahren zum Betreiben einer Kühlvorrichtung nach Anspruch 7, **dadurch gekennzeichnet, dass** der Zusatzstoff ein Alkohol, ein Saccharid oder ein Formiat enthält.

## Claims

1. Cooling device (2) for cooling electrical components in the form of a power semiconductor (4) comprising a cooling circuit (6) with a cooling medium (8) on the basis of water, and also an electrode (10) around which the cooling medium flows, **characterized in that** the cooling medium contains between 1% by volume and 10% by volume of a water-soluble, non-ionic and non-dissociating additive (9).

2. Cooling device according to Claim 1, **characterized in that** the additive contains an alcohol or a saccharide or a formate.

3. Cooling device according to Claim 1 or 2, **characterized in that** the electronic component (4) is a thyristor or an IGBT.

4. Cooling device according to one of the preceding claims, **characterized in that** the electrical component (4) is part of a power converter installation.

5. Cooling device according to Claim 4, **characterized in that** the power converter installation is part of a high-voltage direct-current transmission system.

6. Cooling device according to one of the preceding claims, **characterized in that** the cooling device comprises an ion exchanger (12).

7. Method for operating a cooling device, for cooling electrical components (4) in the form of a power semiconductor, comprising a cooling circuit (6) and also an electrode (10) around which the cooling medium flows, comprising the following step: filling the cooling device with a water-based cooling medium, which contains a water-soluble, non-ionic and non-dissociating substance making up between 1% by volume and 10% by volume of the cooling medium.

8. Method for operating a cooling device according to Claim 7, **characterized in that** the additive contains an alcohol, a saccharide or a formate.

## Revendications

1. Dispositif (2) de refroidissement de composants électriques sous la forme d'un semi-conducteur (4) de puissance, comprenant un circuit (6) de refroidissement par un fluide (8) de refroidissement à base d'eau, ainsi qu'une électrode (10) autour de laquelle passe le fluide de refroidissement, **caractérisé en ce que** le fluide de refroidissement contient entre 1% en volume et 10% en volume d'un additif (9) soluble dans l'eau non ionique et ne se dissociant pas.

2. Dispositif de refroidissement suivant la revendication 1, **caractérisé en ce que** l'additif contient un alcool ou un saccharide ou un formiate.

3. Dispositif de refroidissement suivant la revendication 1 ou 2, **caractérisé en ce que** le composant (4) électronique est un thyristor ou un IGBT.

4. Dispositif de refroidissement suivant l'une des revendications précédentes, **caractérisé en ce que** le composant (4) électrique fait partie d'un système de convertisseur.

5. Dispositif de refroidissement suivant la revendication 4, **caractérisé en ce que** le système de convertisseur fait partie d'un système de transport de courant continu de haute tension.

6. Dispositif de refroidissement suivant l'une des revendications précédentes, **caractérisé en ce que** le dispositif de refroidissement comprend un échangeur d'ions (12).

7. Procédé pour faire fonctionner un dispositif de refroidissement de composants (4) électriques sous la forme d'un semi-conducteur de puissance, comprenant un circuit (6) de refroidissement, ainsi qu'une électrode (10) autour de laquelle passe un fluide de refroidissement, comprenant les stades suivants :
on remplit le dispositif de refroidissement d'un fluide de refroidissement à base d'eau, qui contient une substance soluble dans l'eau non ionique et ne se dissociant pas, présente dans le fluide de refroidissement à un pourcentage compris entre 1% en volume et 10% en volume.

8. Procédé pour faire fonctionner un dispositif de refroidissement suivant la revendication 7, **caractérisé en ce que** l'additif contient un alcool, un saccharide ou un formiate.
